# EUROPÄISCHE PATENTSCHRIFT

(11) **EP 0 553 225 B1**
(45) Veröffentlichungstag und Bekanntmachung des Hinweises auf die Patenterteilung: **07.01.1998**
(21) Anmeldenummer: 91919262.5
(22) Anmeldetag: 09.10.1991
(51) Int. Cl.: C07F 9/30, C08F 2/46, C08K 5/5313

(54) **ACYL-(2'-HYDROXYBIPHENYL-2-YL)-PHOSPHINSÄURESALZE, IHRE HERSTELLUNG UND VERWENDUNG**
ACYL-(2'-HYDROXYDIPHENYL-2-YL)-PHOSPHINIC ACID SALTS, THEIR PRODUCTION AND USE
SELS D'ACIDE PHOSPHINIQUE D'ACYL-(2'-HYDROXYBIPHENYL-2-YL), LEUR PRODUCTION ET LEUR UTILISATION

(30) Priorität: 19.10.1990 DE 4033215
(43) Veröffentlichungstag der Anmeldung: 04.08.1993
(73) Patentinhaber: Clariant GmbH, 65929 Frankfurt am Main (DE)
(72) Erfinder: KLEINER, Hans-Joerg, D-6242 Kronberg 2 (DE); GERSDORF, Joachim, D-6200 Wiesbaden (DE); BASTIAN, Udo, D-4030 Ratingen (DE)
(86) Internationale Anmeldenummer: EP9101919
(87) Internationale Veröffentlichungsnummer: WO9206983

(56) Entgegenhaltungen:
- EP-A- 0 007 508
- EP-A- 0 057 474
- EP-A- 0 059 988
- EP-A- 0 304 782
- DE-A- 3 827 735

## Beschreibung

Es ist bereits eine Reihe von Photoinitiatoren auf der Basis von Acylphosphinsäureestern und Acylphosphanoxyden bekannt (vgl. EP-Offenlegungsschrift 7508). Desweiteren beschreibt die EP-Offenlegungsschrift 304 782 Acyl-(6H)-dibenz[c,e][1,2]oxaphosphorin-6-oxyde für diesen Zweck. Diese Verbindungen sind jedoch nicht als Photoinitiatoren in wäßrigen, photopolymerisierten Massen geeignet. Aus der EP-Offenlegungsschrift 62 839 sind zwar auch schon Acylphosphonsäuresalze für den Einsatz als Photoinitiatoren in wäßrigen Systemen beschrieben; nachteilig ist dabei jedoch die aufwendige Herstellung dieser Salze, bei der beispielsweise Alkyloxide als Nebenprodukte auftreten.

Die Erfindung hat sich nun zum Ziel gesetzt, neue Acyl-Phosphorverbindungen bereitzustellen, welche die Nachteile des Standes der Technik nicht aufweisen und die insbesondere in technisch besonders einfacher Weise herstellbar sind, dabei aber trotzdem den hohen Anforderungen der Praxis entsprechen und die auch in wäßrigen photopolymerisierbaren Massen gut einsetzbar sind.

Die Erfindung betrifft ein Verfahren zur Herstellung von Acyl-(2'-hydroxybiphenyl-2-yl)-phosphinsäuresalzen der Formel (I) 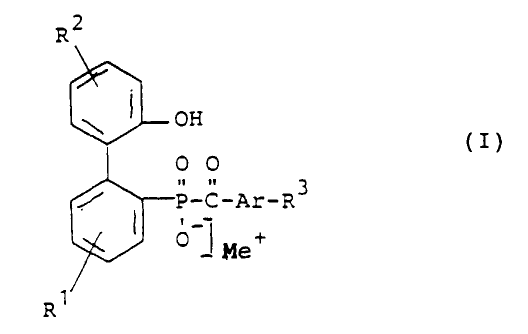 worin jeder der Reste R¹, R² und R³ ein- oder mehrfach, vorzugsweise höchstens dreifach, enthalten sein kann und in der bedeuten

R¹ bis R³ unabhängig voneinander Wasserstoff, einen Alkyl- oder Alkoxyrest mit jeweils 1 bis 6, vorzugsweise 1 bis 4 Kohlenstoffatomen oder Halogen mit einer Ordnungszahl von 9 bis 35, vorzugsweise Chlor,

Ar einen aromatischen Kohlenwasserstoffrest mit 6 bis 10 Kohlenstoffatomen und

Me ein Kation mindestens eines Alkalimetalls, vorzugsweise mit einer Ordnungszahl von 3 bis 19, oder N(R⁴)₄⁺, in dem die Reste R⁴ gleich oder verschieden sind und für einen Alkylrest mit jeweils 1 bis 6, vorzugsweise 1 bis 4 Kohlenstoffatomen stehen.

Diese Verbindungen (I), die eine sehr gute Reaktivität als Photoinitiatoren aufweisen, sind überraschenderweise gut wasserlöslich, obwohl ihr Molekül zum überwiegenden Teil aus hydrophoben Bereichen (Kohlenwasserstoffresten) besteht. Außerdem ist die sehr reaktive 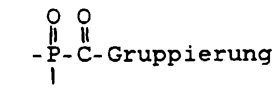 in ihnen überraschend hydrolysestabil.

Bevorzugt werden erfindungsgemäß solche Verbindungen (I) hergestellt, die gekennzeichnet sind durch wenigstens eines der nachfolgenden Merkmale:
a) zumindest einer der beiden Reste R¹ und R² und vorzugsweise beide dieser Reste stehen für Wasserstoff,
b) der Rest R³ bedeutet Wasserstoff oder mindestens einen Alkylrest, vorzugsweise einen bis drei Alkylreste, insbesondere Methylreste,
c) der Rest Ar stellt einen Benzolring dar.

Alkyl oder Alkoxy in den Resten R¹ bis R³ steht insbesondere für Methyl oder Ethyl.

Beispiele für Alkylgruppen sind Methyl, Ethyl, Propyl, Isopropyl und die verschiedenen Butylreste, wobei die beiden ersteren und insbesondere Methyl bevorzugt sind. Bevorzugte Beispiele für Alkoxyreste sind Methoxy und Ethoxy, insbesondere Methoxy.

Außer den in den Beispielen beschriebenen Verbindungen (I) seien hier noch beispielsweise aufgeführt: (4-Methyl-benzoyl)(2'-hydroxybiphenyl-2-yl)-phosphinsäurenatriumsalz, (2,6-Dimethyl-benzoyl)(2'-hydroxybiphenyl-2-yl)-phosphinsäurenatriumsalz, (4-Ethyl-benzoyl)(2'-hydroxybiphenyl-2-yl)-phosphinsäurelithiumsalz, (2,6-Dichlorbenzoyl)(2'-hydroxybiphenyl-2-yl)-phosphinsäurelithiumsalz und (2,6-Dichlor-benzoyl)(2'-hydroxybiphenyl-2-yl)phosphinsäurekaliumsalz.

Gegenstand der Erfindung ist auch ein Verfahren zur Herstellung der Verbindungen (I), dadurch gekennzeichnet, daß man 6-Acyl-(6H)-dibenz[c,e][1,2]oxaphosphorin-6-oxyde der Formel (II) 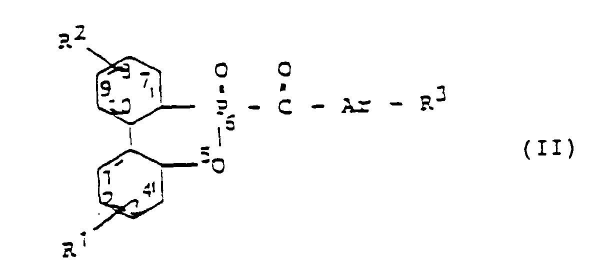 worin R¹ bis R³ und Ar in der obigen Formel (I) angegebene Bedeutung haben, mit Salzen der Kohlensäure der Formeln MeHCO₃ (III) oder Me₂CO₃ (IV), in denen Me jeweils die Bedeutung gemäß Formel (I) hat, umsetzt, wobei im Falle der Carbonate (IV) die Umsetzung in Gegenwart von Wasser erfolgt (siehe hierzu auch das anliegende Formelblatt).

Nach diesem Verfahren werden die Verbindungen (I) überraschenderweise in guten Ausbeuten erhalten.

Die Umsetzung erfolgt zweckmäßigerweise in Anwesenheit eines Verdünnungsmittels, wie beispielsweise Wasser, das im Falle der Carbonate (IV) ohnehin zugegen sein muß. Als weitere Verdünnungsmittel kommen übliche, vorzugsweise mit Wasser mischbare, polare organische Lösungsmittel in Frage, wie Ether bzw. Glykolether, beispielsweise Diethylether, 1,2-Dimethoxyethan, Ethylenglykoldibutylether, Tetrahydrofuran oder Dioxan; Ketone, beispielsweise Aceton, Methylethylketon, Methylisobutylketon, Cyclohexanon und ähnliche; Ester, beispielsweise Ethylacetat, Butylacetat, Ethylenglykolmonoethylacetat, Methoxypropylacetat; N-Methyl-pyrrolidon; ein- oder mehrwertige Alkohole wie Methanol, Ethanol, Isopropanol, Butanol, Ethylenglykolmonoethyl(butyl)ether etc. Weiterhin Acetonitril, Formamid und Dimethylformamid. Diese Lösemittel können auch in Mischung untereinander eingesetzt werden.

Bevorzugte Lösemittel sind dabei die niederen Alkohole, insbesondere Isopropanol.

Weitere bevorzugte Verdünnungsmittel sind Gemische aus organischen Lösungsmitteln, insbesondere niederen Alkoholen, und Wasser, wobei der Wasseranteil im allgemeinen 5 bis 60 Gew.-%, vorzugsweise 15 bis 40 Gew.-%, bezogen auf die Mischung, beträgt.

Das erfindungsgemäße Verfahren wird zweckmäßigerweise so durchgeführt, daß man zu einer Komponente die zweite allmählich zudosiert, wobei Kohlendioxid abgespalten wird. Bevorzugt wird dabei die Verbindung (II) vorgelegt. Im allgemeinen wird bei Temperaturen von 20 bis 80°C, vorzugsweise 40 bis 70°C, und bei Normaldruck gearbeitet. Jedoch können in Sonderfällen auch noch höhere Temperaturen und Unter- oder Überdruck angewendet werden.

Als Bicarbonate (III) bzw. Carbonate (IV) kommen bevorzugt diejenigen des Lithiums, Natriums oder Kaliums oder entsprechende Gemische in Frage.

Die als Ausgangsstoffe für das erfindungsgemäße Verfahren eingesetz'ten Verbindungen (II) sind aus der EP-Offenlegungsschrift 304 782 bekannt und in einfacher Weise herstellbar. Auf diese Literaturstelle wird hiermit Bezug genommen.

Die Aufarbeitung der anfallenden Verbindungen (I) geschieht in üblicher Weise, z.B. durch Kristallisation.

Die erfindungsgemäßen Verbindungen (I) zeigen eine sehr gute Reaktivität als Photoinitiatoren für die Photopolymerisation ungesättigter Verbindungen mit mindestens einer C-C-Mehrfachbindung und Mischungen derselben miteinander und mit Zusatzstoffen. Ein wesentlicher Vorteil dieser erfindungsgemäßen Verbindungen (I) ist dabei auch deren gute Löslichkeit, Dispergierbarkeit und/oder Verträglichkeit sowohl in bzw. mit polaren als auch unpolaren Medien. Damit wird z.B. im Falle des Einsatzes in Aufzeichnungsmassen oder Druckfarben ein Auswaschen der unbelichteten und unvernetzten Anteile einer Schicht der photopolymerisierbaren Aufzeichnungsmassen nach ihrer bildmäßigen Belichtung ermöglicht bzw. ein gutes Vermischen der Salze in wäßrigen UV-Lack- oder Druckfarbensystemen erreicht.

Die vorliegende Erfindung betrifft daher auch photopolymerisierbare Massen, welche die erfindungsgemäßen Verbindungen (I) enthalten.

Die photopolymerisierbaren Massen der Erfindung, beispielsweise für die Herstellung von Druckplatten und Reliefformen sowie zur Herstellung von durch Strahlung härtbaren Lacksystemen und Druckfarben, enthalten als wesentliche Bestandteile mindestens ein Bindemittel, mindestens ein niedermolekulares polymerisierbares Monomeres, mindestens einen Photoinitiator, sowie gegebenenfalls ein Verdünnungsmittel und übliche Additive.

Der Begriff "photopolymerisierbare Massen" soll hier entsprechende Überzugsmittel, Lacke, Druckfarben und Aufzeichnungsmaterialien, weiterhin photopolymerisierbare, wäßrige Lösungen, Dispersionen und Emulsionen sowie Verguß-, Spachtel- oder Dichtungsmassen umfassen.

Als Photoinitiator wird in den photopolymerisierbaren Massen gemäß der Erfindung mindestens eine Verbindung (I) eingesetzt, wobei deren Menge im allgemeinen 0,01 bis 20 Gew.-%, vorzugsweise 0,1 bis 5 Gew.-%, bezogen auf die photopolymerisierbare Masse, beträgt. Es können auch Gemische von Verbindungen (I) verwendet werden.

Diese Photoinitiatoren (I) können gegebenenfalls auch mit bekannten Beschleunigern kombiniert werden, die den hemmenden Einfluß des Luftsauerstoffs auf die Photopolymerisation beseitigen und zumeist in Mengen von 0,1 bis 15 Gew.-%, vorzugsweise 1 bis 5 Gew.-%, bezogen auf (I), eingesetzt werden. Solche Beschleuniger bzw. Synergisten sind vor allem Amine, vorzugsweise tertiäre Amine. Beispielsweise seien hier genannt: Diethanolamin, N-Methyldiethanolamin, N-Phenyldiethanolamin, N,N-Dimethyl-ethanolamin, Triethylamin, Triethanolamin, p-Dimethylamino-benzoesäureethylester, Benzylmethylamin, Benzyldimethylamin, Dimethylaminoethylacrylat, N-Methyl-N-phenylglycin und analoge, dem Fachmann bekannte Verbindungen. Zur Beschleunigung der Aushärtung können weiterhin aliphatische und/oder aromatische Halogenide dienen, wie 2-Chlormethylnaphthalin, 1-Chlor-2-chlormethylnaphthalin, sowie Radikalbildner, wie Peroxide und Azo-Verbindungen.

Nach einer weiteren vorteilhaften Ausführungsform können die erfindungsgemäßen Verbindungen (I) auch in Kombination mit bekannten Photoinitiatoren, wie sie beispielsweise in der EP-Offenlegungsschrift 304 782 beschrieben sind, in allen Mengenverhältnissen, z.B. 0,5:1 bis 30:1, vorzugsweise von 0,8:1 bis 10:1 und insbesondere von 1:1 bis 3:1 eingesetzt werden. Derartige geeignete Initiatoren sind z.B. aromatische Ketone und deren funktionelle Derivate, wie Ketale, z.B. Benzyldimethylketal, 2-Hydroxy-2-methyl-1-phenylpropan-1-on, Diethoxyacetophenon, Benzophenon sowie Derivate vom Thioxanthon oder Gemische aus diesen.

Hierbei geht man sinnvoller Weise so vor, daß man die handelsüblichen Initiatoren, die Thioxanthane, Benzophenone, Hydroxyalkylphenone oder auch Acylphosphanoxide im Bindemittel-/Monomerengemisch löst, diese Mischung in Wasser emulgiert oder dispergiert und anschließend die wäßrige Lösung des erfindungsgemäßen Salzes unter Rühren zugibt. Soweit es die Löslichkeit dieses Salzes zuläßt, können diese auch in 100 %-Systemen, d.h. lösemittelfreien Systemen, gelöst werden.

Der Gesamtgehalt an diesen Kombinationen liegt im allgemeinen zwischen 0,01 und 20 Gew.-%, vorzugsweise 0,1 bis 5 Gew.-%, bezogen auf das Gewicht der gesamten polymerisierbaren Masse.

Die erfindungsgemäßen Salze (I) können mit den bekannten Photoinitiatoren auch in der Weise kombiniert werden, daß der entsprechende Emissionsbereich der UV-Strahler voll dem Absorptionsbereich der Initiatorkombination entspricht (z.B. 300 - 420 nm oder 200 - 420 nm).

Ein besonderer Vorteil dieser Photoinitiatorkombinationen besteht darin, daß hierdurch eine deutliche Erhöhung der Aushärtungsgeschwindigkeit und eine bessere Härte der ausgehärteten Filme erzielt wird. Ein weiterer Vorteil dieser Photoinitiatorkombinationen ist, daß sie kostengünstig sind. Weiterhin können mit Hilfe dieser Kombinationen auch pigmentierte wäßrige oder 100 %-Systeme ausgehärtet werden.

Als photopolymerisierbare Monomere eignen sich die üblichen Verbindungen und Stoffe mit polymerisierbaren C-C-Doppelbindungen, die durch z.B. Aryl-, Carbonyl-, Amino-, Amid-, Amido-, Ester-, Carboxy- oder Cyanid-Gruppen, Halogenatome oder C-C-Doppel- oder C-C-Dreifachbindungen aktiviert sind. Genannt seien beispielsweise Vinylether und Vinylester, Styrol, die verschiedenen Vinyltoluole, Allylether, Acryl- und Methacrylsäure sowie deren Ester mit ein- und/oder mehrwertigen Alkoholen, deren Nitrile oder Amide, weiterhin Mono- oder Diacrylate bzw. -methacrylate von oligomeren Glykolen sowie Acryl- und Methacrylsäureester der Reaktionsprodukte von mehrwertigen Alkoholen mit Glykolen, wie Trimethylolpropantriethoxytriacrylat, Malein- und Fumarester sowie N-Vinylpyrrolidon, N-Vinylcaprolactam, N-Vinylcarbazol und Allylester, wie Diallylphthalat.

Als Bindemittel in den erfindungsgemäßen photopolymerisierbaren Massen können eine Vielzahl von löslichen organischen Polymeren Einsatz finden. Als Beispiele hierfür seien genannt: Polyamide, besonders alkohollösliche Copolyamide, wie sie in der FR-Patentschrift 1 520 856 beschrieben sind, Cellulosederivate, insbesondere wäßrig-alkalisch abwaschbare Cellulosederivate, Vinylalkohol-Polymere sowie Polymere und Copolymere von Vinylestern gesättigter aliphatischer Monocarbonsäuren mit 2 bis 4 C-Atomen, wie Vinylacetat oder Vinylpropionat, mit unterschiedlichem Verseifungsgrad, Polyurethane, Polyetherurethane und Polyesterurethane, Polyvinylacetale, Epoxidharze, Polyacrylsäureester, Polymethacrylsäureester, Polyester, insbesondere ungesättigte Polyesterharze, wie sie weiter unten beschrieben sind, Alkydharze, Polybutadien, Polyisopren, Isopren-Styrol-Blockcopolymere und andere Elastomere, sowie Mischpolymerisate der Monomeren, die die aufgezählten Homopolymerisate bilden.

Von den durch Umsetzung von ungesättigten und gegebenenfalls gesättigten mehrbasischen Carbonsäuren mit mehrwertigen Alkoholen hergestellten Polyestern linearer oder verzweigter Natur sind solche mit einer höheren Säurezahl und insbesondere einer Säurezahl zwischen 75 und 160 bevorzugt, da sie in den Massen zu einer guten Dispergierbarkeit oder Löslichkeit in alkalisch-wäßrigen Entwicklerlösungsmitteln führen.

Als ungesättigte Polyesterharze sind beispielsweise solche geeignet, die hergestellt sind durch Umsetzung von α,β-olefinisch ungesättigten Dicarbonsäuren, wie Maleinsäure, Fumarsäure oder Itaconsäure, gegebenenfalls im Gemisch mit gesättigten bzw. aromatischen Dicarbonsäuren, wie Adipinsäure, Ortho-, Iso-, Terephthalsäure, oder Tetrahydrophthalsäure, mit Alkandiolen, wie Ethylenglykol, Propylenglykol, Butandiol', Neopentylglykol oder oxalkyliertem Bisphenol A; weiterhin Epoxidacrylate, hergestellt aus Acryl- oder Methacrylsäure und aromatischen oder aliphatischen Diglycidylethern und Urethanacrylate, z.B. hergestellt aus Hydroxyalkylacrylaten und Polyisocyanaten, sowie Polyesteracrylate, z.B. hergestellt aus hydroxylgruppenhaltigen gesättigten Polyestern und Acryl- oder Methacrylsäure.

Ebenso können Bindemittel Verwendung finden, die wasserunlöslich, aber in wäßrig-alkalischen Lösungen löslich oder mindestens quellbar sind, da sich Schichten mit solchen Bindemitteln mit wäßrig-alkalischen Entwicklern entwickeln lassen. Derartige Bindemittel können z.B. die folgenden Gruppen enthalten: -COOH, PO₃H₂, -SO₂NH-; -SO₂-NH-SO₂- und -SO₂-NH-CO-.
Als Beispiele hierfür seien genannt: Maleinatharze, Polymerisate aus N-(p-Tolyl-sulfonyl)-carbaminsäure-β-(methacryloyloxy)-ethylester und Mischpolymerisate dieser und ähnlicher Monomerer mit anderen Monomeren, Vinylacetat/Crotonsäure, Styrol/Maleinsäureanhydrid, Alkylmethacrylat/Methacrylsäure, höheren Alkylmethacrylaten und Methylmethacrylat und/oder Styrol oder Acrylnitril.

Mit besonderem Vorteil werden Gemische auf Basis wasserlöslicher Bindemittel eingesetzt, da sich die erfindungsgemäßen Verbindungen mit diesen besonders leicht kombinieren lassen und eine bequeme und umweltfreundliche Beschichtung aus wäßriger Lösung erlauben. Beispiele für solche Bindemittel sind Polyvinylalkohol, teilverseifte Polyvinylacetale und Vinylacetat-Mischpolymerisate, teilverseifte Vinylacetat-Pfropfpolymere, wie sie in der DE-Offenlegungsschrift 37 32 089 beschrieben sind, Polyvinylether, Polyvinylpyrrolidon, Polyacrylamid, Poly-dimethylacrylamid, Polyethylenoxid, Polyvinylmethyl-formamid, Polyvinylmethylacetamid sowie wasserlösliche natürliche Polymere.

Die erfindungsgemäßen Massen bestehen überwiegend, d.h. zu mehr als 50 und bevorzugt zu 70 bis 100 Gew.-% aus der Photoinitiator enthaltenden Mischung aus Monomeren und Bindemittel. Der Gehalt dieser Mischung an polymerem Bindemittel beträgt im allgemeinen etwa 45 bis 95 und insbesondere 45 bis 65 Gew.-%, bezogen auf die Summe der Mengen an Monomeren und Bindemittel.

Den photopolymerisierbaren Massen, deren Zusammensetzung für den jeweiligen Verwendungszweck dem Fachmann geläufig ist, können in an sich bekannter Weise zusätzlich gesättigte und/oder ungesättigte Polymere sowie weitere Zusatzstoffe wie Inhibitoren gegen die thermische Polymerisation, Paraffin, Pigmente, Farbstoffe, Peroxide, Verlaufshilfsmittel, Füllstoffe, Mattierungsmittel und Glasfasern sowie Stabilisatoren gegen thermischen oder photochemischen Abbau zugesetzt sein. Art und Menge der Zusätze hängen vom jeweiligen Verwendungszweck ab. Gleiches gilt auch für die Art und Menge des eventuell vorhandenen Verdünnungsmittels.

Die Verarbeitung der photopolymerisierbaren Massen kann in üblicher Weise erfolgen und ist davon abhängig, ob die Masse flüssig oder fest ist. Sie erfolgt durch Belichten, z.B. mit aktinischem Licht. Danach werden z.B. für die Herstellung von Reliefdruckformen oder Photoresists die nichtbelichteten Anteile der Schicht der Aufzeichnungsmassen in üblicher Art mechanisch entfernt oder mit einem geeigneten Entwicklungslösungsmittel ausgewaschen und die resultierenden Formen getrocknet, in manchen Fällen auch noch voll nachbelichtet.

Beim Verarbeiten von wäßrigen, durch energiereiche Strahlung härtbarer Systeme muß vor der Bestrahlung mit z.B. aktinischer Strahlung das Wasser aus dem zu härtenden Film entfernt werden, da sonst nur eine unvollständige Härtung des Materials stattfindet: Das geschieht in der Regel durch Einsatz von IR-Trocknern oder Trockenöfen, z.B. Umlufttrocknern.

Die Durchführung der Photopolymerisation wäßriger Lösungen oder Emulsionen von geeigneten Monomeren unter Einsatz der erfindungsgemäßen Verbindungen (I) kann gleichfalls in bekannter Weise erfolgen, z.B. wie in der EP-Offenlegungsschrift 62 839 beschrieben.

Als Strahlungsquellen für das die Polymerisation solcher Systeme auslösende Licht verwendet man im allgemeinen solche, die Licht vorzugsweise im Absorptionsbereich der erfindungsgemäßen Verbindungen (I) aussenden, d.h. zwischen 300 und 450 nm. Besonders geeignet sind Quecksilber-Niederdruckstrahler, -Mitteldruck- und -Hochdruckstrahler, sowie (superaktinische) Leuchtstoffröhren oder Impulsstrahler. Die genannten Lampen können gegebenenfalls dotiert sein. Weiterhin können auch Strahlungsquellen eingesetzt werden, die annähernd monochromatisches Licht emittieren.

Die nachfolgenden Beispiele erläutern die Erfindung näher.

### Beispiele

### I. Herstellungsbeispiele

1. (2-Methyl-benzoyl)-(2'-hydroxybiphenyl-2-yl)-phosphinsäure-kaliumsalz
50,1 g (0,15 Mol) 6-(2-Methyl-benzoyl)-(6H)-dibenz[c,e][1,2]-oxaphosphorin-6-oxid wurden in 218 g Isopropanol und 45 ml Wasser bei 60°C gelöst. Nun wurden während 30 Minuten 15 g (0,15 Mol) Kaliumhydrogencarbonat portionsweise unter Kohlendioxidentwicklung zugegeben. Es wurde noch 2 Stunden bei 60°C nachgerührt und anschließend abgesaugt. Man erhielt 39 g (67 % der Theorie) der obengenannten Verbindung mit einem Zersetzungspunkt von etwa 280°C.

| | | | | | |
|---|---|---|---|---|---|
| C₂H₁₀KO₄P | ber. | 61,54 % C | 4,10 % H | 10,00 % K | 7,95 % P |
| (390) | gef. | 61,5 % C | 4,0 % H | 9,5 % K | 7,8 % P |

2. (2-Methyl-benzoyl)(2'-hydroxybiphenyl-2-yl)-phosphinsäurelithiumsalz
39 g (0,117 Mol) 6-(2-Methyl-benzoyl)-(6H)-dibenz[c,e][1,2]-oxaphosphorin-6-oxid wurden in 170 g Isopropanol und 35 ml Wasser bei 60°C gelöst. Nun wurden während 15 Minuten 4,3 g (0,0584 Mol) Lithiumcarbonat unter Kohlendioxidentwicklung zugegeben. 2 Stunden wurde bei 60°C nachgerührt und anschließend abgesaugt. Man erhielt 23,7 g. Nach dem Einengen wurden aus der Mutterlauge weitere 13,3 g gewonnen. Insgesamt wurden 37 g (89 % der Theorie) der obengenannten Verbindung mit einem Zersetzungspunkt von etwa 250°C erhalten.

| | | | | | |
|---|---|---|---|---|---|
| C₂₀H₁₆LiO₄P | ber. | 67,04 % C | 5,59 % H | 1,96 % Li | 8,66 % P |
| (358) | gef. | 67,1 % C | 5,6 % H | 1,7 % Li | 8,3 % P |

3. (2,4,6-Trimethyl-benzoyl)-(2'-hydroxybiphenyl-2-yl)phosphinsäure-natriumsalz
108,6 g (0,3 Mol) 6-(2,4,6-Trimethyl-benzoyl)-(6H)dibenz[c,e][1,2]-oxaphosphorin-6-oxid wurden in 435 g Isopropanol und 90 g Wasser bei 60°C gelöst. Nun wurden während 30 Minuten 25,2 g (0,3 Mol) Natriumhydrogencarbonat bei dieser Temperatur portionsweise zugegeben, wobei Kohlendioxid abgaste. Dann wurde 8 Stunden bei 40 - 60°C nachgerührt. Nach dem Absaugen erhielt man 63,5 g; aus dem Filtrat konnten nach dem Einengen weitere 50 g gewonnen werden. Insgesamt wurden 113,5 g (94 % der Theorie) der obengenannten Verbindung mit einem Zersetzungspunkt von 230 - 237°C erhalten.

| | | | | | |
|---|---|---|---|---|---|
| C₂₂H₂₀NaO₄P | ber. | 65,67 % C | 4,97 % H | 5,72 % Na | 7,71 % P |
| (402) | gef. | 65,5 % C | 4,8 % H | 5,2 % Na | 6,8 % P |

4. (2,4,6-Trimethyl-benzoyl)-(2'-hydroxybiphenyl-2-yl)phosphinsäure-kaliumsalz
36,2 g (0,1 Mol) 6-(2,4,6-Trimethyl-benzoyl)-(6H)-dibenz[c,e][1,2]-oxaphosphorin-6-oxid wurden in 145 g Isopropanol und 30 ml Wasser bei 60°C gelöst. Nun wurden 10 g (0,1 Mol) Kaliumhydrogencarbonat in 10 Minuten zugegeben, dabei gaste Kohlendioxid ab. Beim Nachrühren kristallisierte die obengenannte Verbindung aus. Man erhielt 39,5 g (95 % der Theorie) mit einem Zersetzungspunkt von etwa 300°C.

| | | | | | |
|---|---|---|---|---|---|
| C₂₂H₂₀KO₄P | ber. | 63,16 % C | 4,79 % H | 9,33 % K | 7,42 % P |
| (418) | gef. | 63,1 % C | 4,8 % H | 9,1 % K | 7,3 % P |

5. (2,4,6-Trimethyl-benzoyl)-(2'-hydroxybiphenyl-2-yl)phosphinsäure-lithiumsalz
36,2 g (0,1 Mol) 6-(2,4,6-Trimethyl-benzoyl)-(6H)-dibenz[c,e][1,2]-oxaphosphorin-6-oxid wurden in 145 g Isopropanol und 30 ml Wasser bei 60°C gelöst. Nun wurden 3,.7 g (0,05 Mol) Lithiumcarbonat portionsweise unter Kohlendioxidentwicklung zugegeben. Anschließend wurde die Temperatur auf 75°C erhöht und 5 Stunden nachgerührt. Dann wurde filtriert und das Filtrat weitgehend von Lösungsmittel befreit. Es verblieben 37 g (96 % der Theorie) der oben genannten Verbindung mit einem Zersetzungspunkt von etwa 135°C.

| | | | | | |
|---|---|---|---|---|---|
| C₂₂H₂₀LiO₄P | ber. | 68,39 % C | 5,18 % H | 1,81 % Li | 8,03 % P |
| (386) | gef. | 68,4 % C | 5,2 % H | 1,7 % Li | 7,9 % P |

6. (1-(2-Methyl-naphthoyl))-(2'-hydroxybiphenyl-2-yl)-phosphinsäure-lithiumsalz
32,6 g (0,085 Mol) 6-(1-(2-Methyl-naphthoyl))-(6H)-dibenz[c,e][1,2]-oxaphosphorin-6-oxid wurden in einer Mischung von 123 g Isopropanol und 25 g Wasser digeriert. Das Reaktionsgemisch wurde dann unter Rühren zum Rückfluß erhitzt. Nun wurden 3,15 g (0,0425 Mol) Lithiumcarbonat während einer Stunde portionsweise unter Kohlendioxidentwicklung zugegeben. Dann wurde zwei Stunden nachgerührt und anschließend im Vakuum weitgehend vom Lösungsmittel befreit. Es verblieben 31 g (89 % der Theorie) der obengenannten Verbindung mit einem Schmelzpunkt von 120 - 130°C und einem Zersetzungspunkt von 160°C.

| | | | | | |
|---|---|---|---|---|---|
| C₂₄H₁₈LiO₄P | ber. | 70,59 % C | 4,41 % H | 1,72 % Li | 7,60 % P |
| (408) | gef. | 70,5 % C | 4,4 % H | 1,6 % Li | 7,3 % P |

7. (1-(2-Methyl-naphthoyl))-(2'-hydroxybiphenyl-2-yl)phosphinsäure-kaliumsalz
32,6 g (0,085 Mol) 6-(1-(2-Methyl-naphthoyl))-(6H)-dibenz[c,e][1,2]-oxaphosphorin-oxid wurden in eine Mischung von 150 ml Tetrahydrofuran und 25 ml Wasser gegeben und unter Rühren auf 60°C erwärmt. Nun wurden 8,5 g (0,085 Mol) Kaliumhydrogencarbonat portionsweise während einer Stunde zugegeben. Es wurde 1,5 Stunden nachgerührt, dann abgekühlt und abgesaugt. Man erhielt 32,2 g (86 % der Theorie) der oben genannten Verbindung mit einem Zersetzungspunkt von 280°C.

| | | | | | |
|---|---|---|---|---|---|
| C₂₄H₁₈KO₄P | ber. | 65,46 % C | 4,09 % H | 8,86 % K | 7,05 % P |
| (440) | gef. | 65,1 % C | 4,1 % H | 8,7 % K | 6,9 % P |

### II. Anwendungsbeispiele

1. 145,5 Gewichtsteile eines innerlich weichgemachten Vinylalkohol-Copolymeren mit einer Viskosität von 4 mPas in 4 %iger wäßriger Lösung bei 20°C und der Esterzahl 150 wurden durch Rühren in 147 Gewichtsteilen Wasser bei 90°C gelöst. Nach Abkühlung auf 60°C wurden unter Rühren 95,8 Gewichtsteile Diethylenglykolmonoacrylat, 5,3 Gewichtsteile Trimethylolpropantriacrylat, 2,1 Gewichtsteile 2,6-Di-tert.-butyl-4-methylphenol und 5,3 Gewichtsteile (2-Methylbenzoyl)-(2'-hydroxybiphenyl-2-yl)-phosphinsäure-kaliumsalz gemäß Herstellungsbeispiel 1 zugegeben. Die homogene Lösung wurde auf eine 0,125 mm dicke Polyethylenterephthalatfolie schichtförmig so aufgetragen, daß nach 48-stündigem Trocknen bei Raumtemperatur eine ca. 1 mm dicke lichtempfindliche Schicht resultierte. Auf die freie Schichtoberfläche wurde ein mit einem Polyurethan-Haftlack gemäß DE-AS 15 97 515 versehenes 0,3 mm dickes Aluminiumblech aufgelegt und das Mehrschichtelement in einer Plattenpresse bei 100°C zwei Minuten gepreßt. Der Haftlack wurde durch Umsetzen eines verzweigten Polyesters aus Adipinsäure, Glycerin und Butylenglykol (5,2 % OH-Gruppengehalt) mit Triphenylmethan-4,4',4"-triisocyanat erhalten. Die Dicke der Distanzstücke wurde so gewählt, daß nach dem Heißpressen eine 0,6 mm dicke Photopolymerschicht erhalten wurde. Nach dem Abziehen der Polyesterfolie wurde die lichtempfindliche Schicht bildmäßig zwei Minuten mit einem handelsüblichen UVA-Flachbelichter (Emissionswellenlängenbereich 320 bis 400 nm, Intensität 10 mW/cm²) belichtet. Nach dem Auswaschen der nichtbelichteten Bildstellen mit warmem Wasser wurde eine Reliefdruckform erhalten.
2. 57,4 Gewichtsteile eines verseiften Pfropfpolymerisats, das eine Grenzviskositätszahl von 10,0 ml/g in Wasser und einen Hydrolysegrad von 90,6 % aufwies und dessen Herstellung in der DE-Offenlegungsschrift 39 16 463 beschrieben wurde, 37,8 Gewichtsteile Diethylenglykolmonomethyletheracrylat, 2,0 Gewichtsteile Trimethylolpropantriacrylat, 0,8 Gewichtsteile 2,6-Di-tert.-butyl-4-methylphenol, 0,005 Gewichtsteile Fettschwarz HB (C.I. 26150) und 2,0 Gewichtsteile (2,4,6-Trimethyl-benzoyl)(2'-hydroxybiphenyl-2-yl)-phosphinsäure-natriumsalz gemäß Hertellungsbeispiel 3 wurden gemischt und bei 165°C in einem Zweischneckenextruder zu einer transparenten Schmelze homogenisiert. Anschließend wurde diese Schmelze in einer Plattenpresse zwischen einer 0,125 mm dicken Polyesterfolie und einem 0,3 mm dicken anodisch oxidierten Aluminiumblech, das mit einer Polyurethanschicht versehen war, bei 155°C zwei Minuten zu einer 0,8 mm dicken Schicht heißgepreßt. Nach Abziehen der Polyesterfolie wurde zwei Minuten mit einem UVA-Flachbelichter belichtet und drei Minuten mit Wasser von 40°C entwickelt. Nach dem Trocknen erhielt man eine Reliefdruckplatte. Die Härte der vernetzten Photopolymerschicht betrug 54 Shore A.

### Anwendungsbeispiele 3 - 5

### Allgemeine Vorschrift:

Zur Herstellung der nachfolgend beschriebenen wäßrigen, durch UV-Strahlung härtbaren Lack- und Druckfarbensysteme wurden die dem Fachmann geläufigen ungesättigten, radikalisch polymerisierbaren Polymeren, Oligomeren und Monomeren, gegebenenfalls nach Zusatz eines Photoinitiators aus der Reihe der Hydroxyalkylphenone, Thioxanthone, Benzophenone oder auch Acylphosphanoxide in Wasser mit Hilfe eines Emulgators emulgiert bzw. dispergiert und anschließend mit einer wäßrigen Lösung der erfindungsgemäßen Verbindung (I) und gegebenenfalls mit in Wasser dispergieren Pigmenten oder in Wasser gelösten Farbstoffen versetzt.

Soweit sich die Photoinitiatorsalze in den beschriebenen ungesättigten Polymeren, Oligomeren und Monomeren oder Gemischen davon lösen, können sie auch in 100 %-Systemen eingesetzt werden (wasserfrei, lösemittelfrei).
Die Aushärtung erfolgte mit Quecksilberdruckstrahlern (2 x 20 cm / 100 W/cm).
3. UV-Glanzlack (wäßrig)

| | | |
|---|---|---|
| a) | Epoxyacrylat | 46,00 |
| b) | Dipropylenglykoldiacrylat | 11,50 |
| c) | Emulgator | 2,00 |
| d) | (2,4,6-Trimethyl-benzoyl)-(2'-hydroxybiphenyl-2-yl)-phosphinsäure-Lithiumsalz | 2,10 |
| e) | Wasser | 40,00 |

Die Lackfilme wurden bei einer Bandgeschwindigkeit von 1 - 10 m/min ausgehärtet. Die Applikation erfolgte z.B. auf Polyesterfolien, Polycarbonat und verschiedenen Metallsubstraten, usw.
4. Pigmentierte UV-Lacke (wäßrig)

| | | |
|---|---|---|
| a) | Epoxyacrylat | 39,00 |
| b) | Dipropylenglykoldiacrylat | 13,00 |
| c) | Emulgator | 2,00 |
| d) | ^{(R)} Borchigel DP 40 (Firma Borchers) | 2,00 |
| e) | (2-Methyl-benzoyl)-(2'-hydroxybiphenyl-2-yl)-phosphinsäure-kaliumsalz (Herstellungsbeispiel 1) | 1,80 |
| f) | Wasser | 46,00 |

Die Lackfilme wurden bei einer Bandgeschwindigkeit von 1 - 15 m/min je nach Schichtstärke des Lackfilms, ausgehärtet. Die Applikation erfolgte wie im Beispiel 3.

In analoger Weise wurden auch andere wäßrige Pigmentdispersionen, wie ^{(R)}Colanyl-Gelb FGL 130 (Hoechst) und ^{(R)}Colanyl-Gelb HR 130 (Hoechst) etc. in den Versuchen erfolgreich eingesetzt.

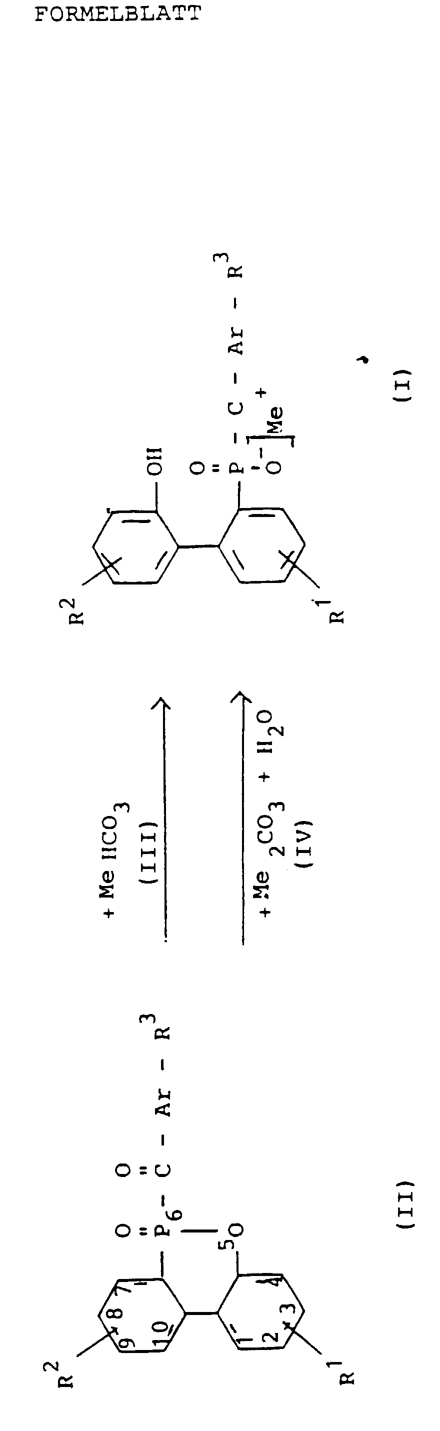

## Patentansprüche

1. Acyl-(2'-hydroxybiphenyl-2-yl)-phosphinsäuresalze der Formel (I) 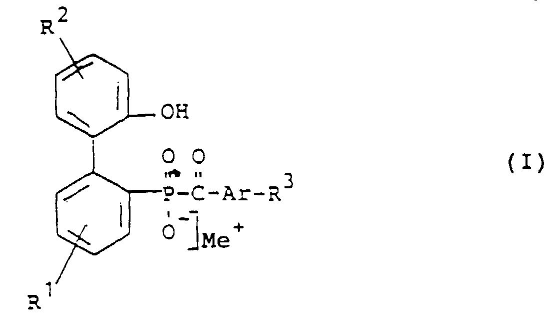 worin jeder der Reste R¹, R² und R³ ein- oder mehrfach enthalten sein kann und in der bedeuten
R¹ und R² unabhängig voneinander Wasserstoff, einen Alkyl- oder Alkoxyrest mit jeweils 1 bis 6 Kohlenstoffatomen oder Halogen mit einer Ordnungszahl von 9 bis 35,
R³ gleiche Bedeutung wie R¹/R²,
Ar einen aromatischen Kohlenwasserstoffrest mit 6 bis 10 Kohlenstoffatomen und
Me ein Kation mindestens eines Alkalimetalls oder N(R⁴)₄⁺, in dem die Reste R⁴ gleich oder verschieden sind und für einen Alkylrest mit jeweils 1 bis 6 Kohlenstoffatomen stehen.

2. Verbindungen nach Anspruch 1, dadurch gekennzeichnet, daß einer der beiden Reste R¹ und R² für Wasserstoff steht und vorzugsweise beide Reste Wasserstoff bedeuten.

3. Verbindungen nach Anspruch 1 oder 2, dadurch gekennzeichnet, daß der Rest R³ Wasserstoff oder mindestens einen Alkylrest, vorzugsweise einen bis drei Alkylreste, bedeutet.

4. Verbindungen nach einem oder mehreren der Ansprüche 1 bis 3, dadurch gekennzeichnet, daß Alkyl für Methyl oder Ethyl steht.

5. Verbindungen nach einem oder mehreren der Ansprüche 1 bis 4, dadurch gekennzeichnet, daß der Rest Ar den Benzolring darstellt.

6. Verfahren zur Herstellung der Verbindungen nach einem oder mehreren der Ansprüche 1 bis 5, dadurch gekennzeichnet, daß man 6-Acyl-(6H)-dibenz[c,e][1,2]oxaphosphorin-6-oxide der Formel (II) 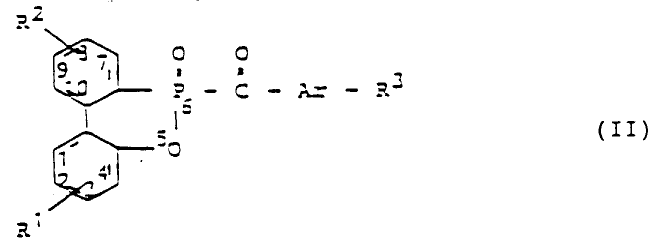 worin R¹ bis R³ und Ar die in den Ansprüchen 1 bis 5 angegebene Bedeutung haben, mit Salzen der Kohlensäüure der Formel MeHCO₃ (III) oder Me₂CO₃ (IV), in denen Me die Bedeutung gemäß Anspruch 1 hat, umsetzt, wobei bei den Salzen (IV) die Umsetzung in Gegenwart von Wasser erfolgt.

7. Verfahren nach Anspruch 6, dadurch gekennzeichnet, daß auch bei Einsatz der Salze (III) Wasser zugegen ist.

8. Verfahren nach Anspruch 6 oder 7, dadurch gekennzeichnet, daß die Umsetzung in Gegenwart eines Gemisches aus organischem Lösungsmittel, vorzugsweise einem Alkohol, und Wasser erfolgt.

9. Verfahren nach einem oder mehreren der Ansprüche 6 bis 8, dadurch gekennzeichnet, daß man bei Temperaturen von 20 bis 80°C, vorzugsweise 40 bis 70°C arbeitet.

10. Photopolymerisierbare Massen, dadurch gekennzeichnet, daß sie die Verbindungen (I) gemäß einem oder mehreren der Ansprüche 1 bis 5 enthalten.

11. Photopolymerisierbare Massen nach Anspruch 10, dadurch gekennzeichnet, daß die Verbindungen (I) in einer Menge von 0,01 bis 15, vorzugsweise 0,1 bis 5 %, bezogen auf das Gewicht der photopolymerisierbaren Masse, zugegen sind.

12. Photopolymerisierbare Massen nach Anspruch 10 oder 11, dadurch gekennzeichnet, daß sie in Form von strahlenhärtbaren Beschichtungsmitteln, insbesondere Klarlacken, pigmentierten Lacken oder Druckfarben, oder in Form von Verguß-, Spachtel- oder Dichtungsmassen vorliegen.

13. Photopolymerisierbare Massen nach einem oder mehreren der Ansprüche 10 bis 12, dadurch gekennzeichnet, daß die Verbindungen (I) in Kombination mit anderen Photoinitiatoren, insbesondere aromatischen Ketonen und/oder Thioxanthon-Derivaten, im Gewichtsverhältnis von 0,5:1 bis 30:1, vorzugsweise von 0,8:1 bis 10:1 verwendet werden, wobei der Gesamtgehalt an Photoinitiatoren zwischen 1 und 20 %, bezogen auf das Gewicht der gesamten polymerisierbaren Masse, liegt.

14. Photopolymerisierbare Massen nach einem oder mehreren der Ansprüche 10 bis 13, dadurch gekennzeichnet, daß sie zusätzlich Beschleuniger, vorzugsweise sekundäre und/oder tertiäre Aminoverbindungen, enthalten.

## Claims

1. An acyl-(2'-hydroxybiphenyl-2-yl)-phosphinic acid salt of the formula (I) 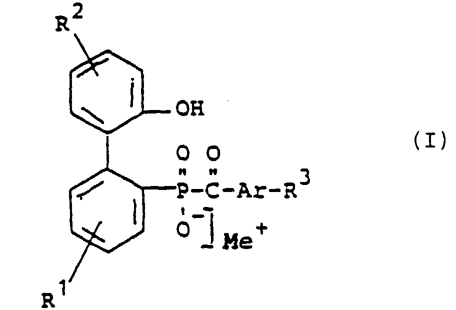 in which each of the radicals R¹, R² and R³ can be present once or several times, and in which
R¹ and R² independently of one another are hydrogen, an alkyl or alkoxy radical having in each case 1 to 6 carbon atoms or halogen having an atomic number of 9 to 35,
R³ has the same meaning as R¹/R²,
Ar is an aromatic hydrocarbon radical having 6 to 10 carbon atoms and
Me is a cation of at least one alkali metal or N(R⁴)₄⁺, in which the radicals R⁴ are identical or different and are an alkyl radical having in each case 1 to 6 carbon atoms.

2. A compound as claimed in claim 1, in which one of the two radicals R¹ and R² is hydrogen, and preferably both radicals are hydrogen.

3. A compound as claimed in claim 1 or 2, in which the radical R³ is hydrogen or at least one alkyl radical, preferably one to three alkyl radicals.

4. A compound as claimed in one or more of claims 1 to 3, in which alkyl is methyl or ethyl.

5. A compound as claimed in one or more of claims 1 to 4, in which the radical Ar is the benzene ring.

6. A process for the preparation of a compound as claimed in one or more of claims 1 to 5, which comprises reacting a 6-acyl-(6H)-dibenz[c,e] [1,2]oxaphosphorine 6-oxide of the formula (II) 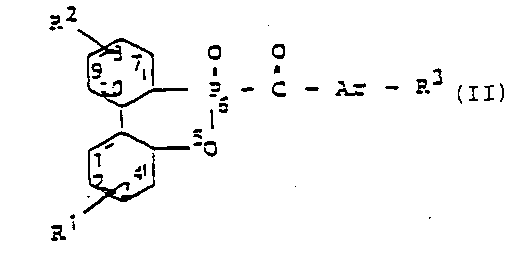 in which R¹ to R³ and Ar have the meaning given in claims 1 to 5, with a salt of carbonic acid of the formula MeHCO₃ (III) or Me₂CO₃ (IV), in which Me has the meaning as claimed in claim 1, the reaction being carried out in the presence of water in the case of a salt (IV).

7. The process as claimed in claim 6, wherein water is also present if a salt (III) is employed.

8. The process as claimed in claim 6 or 7, wherein the reaction is carried out in the presence of a mixture of an organic solvent, preferably an alcohol, and water.

9. The process as claimed in one or more of claims 6 to 8, wherein the reaction is carried out at a temperature of 20 to 80°C, preferably 40 to 70°C.

10. A photopolymerizable composition which comprises a compound (I) as claimed in one or more of claims 1 to 5.

11. A photopolymerizable composition as claimed in claim 10, in which the compound (I) is present in an amount of 0.01 to 15, preferably 0.1 to 5%, based on the weight of the photopolymerizable composition.

12. A photopolymerizable composition as claimed in claim 10 or 11, which is present in the form of a coating agent, in particular a clear paint, pigmented paint or printing ink, which can be cured by radiation or in the form of a grouting, filler or sealing composition.

13. A photopolymerizable composition as claimed in one or more of claims 10 to 12, in which the compound (I) is used in combination with other photoinitiators, in particular aromatic ketones and/or thioxanthone derivatives, in a weight ratio of 0.5:1 to 30:1, preferably 0.8:1 to 10:1, the total content of photoinitiators being between 1 and 20%, based on the weight of the total polymerizable composition.

14. A photopolymerizable composition as claimed in one or more of claims 10 to 13, which additionally comprises accelerators, preferably secondary and/or tertiary amino compounds.

## Revendications

1. Sels d'acides acyl-(2'-hydroxybiphényl-2-yl)phosphiniques de formule (I) 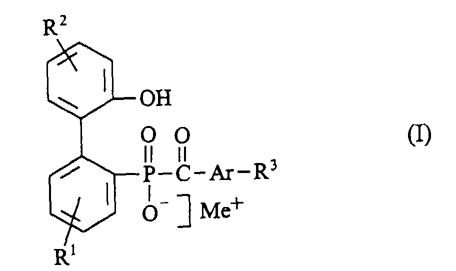 dans laquelle chacun des restes R¹, R² et R³ peut être contenu une ou plusieurs fois, et
R¹ et R² représentent indépendamment l'un de l'autre un atome d'hydrogène, un reste alkyle ou alcoxy ayant chacun 1 à 6 atomes de carbone, ou un atome d'halogène ayant un numéro atomique de 9 à 35;
R³ a la même signification que R¹/R²;
Ar représente un reste hydrocarboné aromatique de 6 à 10 atomes de carbone et
Me est un cation d'au moins un métal alcalin, ou N(R⁴)₄⁺, dans lequel les restes R⁴ sont identiques ou différents et représentent chacun un reste alkyle de 1 à 6 atomes de carbone.

2. Composés selon la revendication 1, caractérisés en ce que l'un des deux restes R¹ et R² représente l'hydrogène et de préférence les deux restes représentent l'hydrogène.

3. Composés selon la revendication 1 ou 2, caractérisés en ce que le reste R³ représente l'hydrogène ou au moins un reste alkyle, de préférence 1 à 3 restes alkyle.

4. Composés selon l'une ou plusieurs des revendications 1 à 3, caractérisés en ce que le reste alkyle est un reste méthyle ou éthyle.

5. Composés selon l'une ou plusieurs des revendications 1 à 4, caractérisés en ce que le reste Ar est un reste benzène.

6. Procédé de préparation des composés selon l'une ou plusieurs des revendications 1 à 5, caractérisé en ce que l'on fait réagir des 6-acyl-(6H)dibenzo[c,e][1,2]oxaphosphorine-6-oxydes de formule (II) 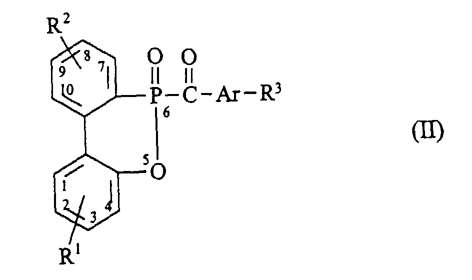 dans laquelle R¹ à R³ et Ar ont la signification donnée dans les revendications 1 à 5, avec des sels de l'acide carbonique de formule MeHCO₃ (III) ou Me₂CO₃ (IV) dans lesquels Me a la signification donnée dans la revendication 1, la réaction s'effectuant en présence d'eau dans le cas des sels (IV).

7. Procédé selon la revendication 6, caractérisé en ce qu'il y a aussi de l'eau lorsque l'on utilise les sels (III).

8. Procédé selon la revendication 6 ou 7, caractérisé en ce que la réaction s'effectue en présence d'un mélange d'un solvant organique, de préférence d'un alcool, et d'eau.

9. Procédé selon l'une ou plusieurs des revendications 6 à 8, caractérisé en ce que l'on travaille à des températures comprises entre 20 et 80°C, de préférence entre 40 et 70°C.

10. Compositions photopolymérisables caractérisées en ce qu'elles contiennent des composés (I) selon l'une ou plusieurs des revendications 1 à 5.

11. Compositions photopolymérisables selon la revendication 10, caractérisées en ce que les composés (I) sont présents en une quantité de 0,01 à 15, de préférence de 0,1 à 5 % par rapport à la masse de la composition photopolymérisable.

12. Compositions photopolymérisables selon la revendication 10 ou 11, caractérisées en ce qu'elles se présentent sous forme de compositions de revêtement durcissables par irradiation, en particulier de vernis clairs, de vernis pigmentés ou d'encres d'impression, ou sous forme de compositions de scellement, de mastics ou de matériaux d'étanchéité.

13. Compositions photopolymérisables selon l'une ou plusieurs des revendications 10 à 12, caractérisées en ce que l'on utilise les composés (I) en combinaison avec d'autres photoamorceurs, en particulier de cétones aromatiques et/ou de dérivés de thioxanthone, dans un rapport en masse de 0,5:1 à 30:1, de préférence de 0,8:1 à 10:1, la teneur totale en photoamorceurs étant comprise entre 1 et 20 % par rapport à la masse de la composition polymérisable totale.

14. Compositions photopolymérisables selon l'une ou plusieurs des revendications 10 à 13, caractérisées en ce qu'elles contiennent en outre des accélérateurs, de préférence des composés amino secondaires et/ou tertiaires.
